(19) Europäisches Patentamt
European Patent Office
Office européen des brevets

(11) EP 4 575 522 A1

(12) EUROPÄISCHE PATENTANMELDUNG

(43) Veröffentlichungstag:
25.06.2025 Patentblatt 2025/26

(21) Anmeldenummer: 24151143.5

(22) Anmeldetag: 10.01.2024

(51) Internationale Patentklassifikation (IPC):
G01R 15/14 (2006.01)      G01R 15/16 (2006.01)
G01R 15/20 (2006.01)      G01R 19/25 (2006.01)
G01R 29/08 (2006.01)

(52) Gemeinsame Patentklassifikation (CPC):
G01R 15/142; G01R 15/16; G01R 15/207;
G01R 19/2513; G01R 29/085

(84) Benannte Vertragsstaaten:
AL AT BE BG CH CY CZ DE DK EE ES FI FR GB
GR HR HU IE IS IT LI LT LU LV MC ME MK MT NL
NO PL PT RO RS SE SI SK SM TR
Benannte Erstreckungsstaaten:
BA
Benannte Validierungsstaaten:
KH MA MD TN

(30) Priorität: 21.12.2023 EP 23218993

(71) Anmelder: Siemens Aktiengesellschaft
80333 München (DE)

(72) Erfinder:
• Gashi, Indrit
81241 München (DE)
• Raab, Oliver
94496 Ortenburg (DE)
• Santos Wilke, Hans
85599 Parsdorf (DE)

(74) Vertreter: Siemens Patent Attorneys
Postfach 22 16 34
80506 München (DE)

(54) **MESSVORRICHTUNG ZUM BESTIMMEN EINER ELEKTRISCHEN GRÖSSE IN EINEM LEITER, ANORDNUNG SOWIE VERFAHREN**

(57) Die Erfindung betrifft eine Messvorrichtung (12) zum Bestimmen einer elektrischen Größe (20) in einem elektrischen Leiter (14), mit zumindest einer Spannungsmesseinrichtung (22) und einer Strommesseinrichtung (24), wobei die Messvorrichtung (12) zum berührungslosen Bestimmen der elektrischen Grö-ße (20) in dem elektrischen Leiter (14) ausgebildet ist, wobei die Messvorrichtung (12) zusätzlich eine Abstandsmesseinrichtung (26) zum Bestimmen eines Abstands (28) der Messvorrichtung (12) zu dem Leiter (14) aufweist. Ferner betrifft die Erfindung eine Anordnung (10) und ein Verfahren.

FIG 1

EP 4 575 522 A1

**Beschreibung**

Die Erfindung betrifft eine Messvorrichtung zum Bestimmen einer elektrischen Größe in einem Leiter, mit zumindest einer Spannungsmesseinrichtung und eine Strommesseinrichtung, wobei die Messvorrichtung zum berührungslosen Bestimmen der elektrischen Größe an dem elektrischen Leiter ausgebildet ist. Ferner betrifft die Erfindung eine Anordnung sowie ein Verfahren zum Bestimmen einer elektrischen Größe.

Die exakte Bestimmung für elektrische Energieverbräuche ist eine wichtige Aufgabe für unterschiedliche Anwendungsfelder, wie zum Beispiel der industriellen Automatisierung, der Gebäudetechnik aber auch in großflächigen elektrischen Verteilernetzen. Insbesondere auch im Zuge der voranschreitenden Umstellung auf erneuerbare Energien und der Dezentralisierung der Energieerzeugung wird es in Zukunft für entscheidende Bedeutung sein, Energieflüsse örtlich hoch aufgelöst abbilden zu können.

Um elektrische Energieflüsse zu messen, ist die präzise, zeitlich hochaufgelöste und gleichzeitige Bestimmung der beiden Größen Strom und Spannung an einem Ort durchzuführen. Zur Durchführung der Messung stehen unterschiedliche Messverfahren zur Verfügung, die jedoch vor allem hinsichtlich der Spannungsmessung nicht ohne einen physischen Kontakt zum Messobjekt auskommen. Hierzu muss entweder die Isolation beschädigt werden oder im Falle von Hochspannungsleitungen ein physischer Kontakt zu einer sicherheitskritischen Spannung hergestellt werden. Dieser physische Kontakt hat insbesondere bei bereits bestehenden Leitungen den Nachteil, dass diese zur Installation zwischenzeitlich vom Netz getrennt werden müssen und im späteren Betrieb strenge Sicherheitsanforderungen eingehalten werden müssen.

Bei Hochspannungsleitungen werden die Energieflüsse typischerweise an einen Einspeise- und Entnahmepunkt mit präzisen Verfahren im Kontakt gemessen. Ein Austausch oder Nachrüsten eines solchen Punktes ist ohne enormen Aufwand und im zeitweisen Abschalten des Netzes jedoch nicht möglich. Darüber hinaus besteht Unklarheit über den Zustand des Netzes zwischen den verschiedenen Messpunkten. Der Abstand dieser Messpunkte kann daher dutzende bis hunderte Kilometer betragen.

Energiemessungen werden mit Hilfe eines Gerätes durchgeführt, welches in die bestehende Stromverbindung (beispielsweise Leitung oder Kabel) eingefügt wird. Dies ist notwendig, weil zumindest die Spannungsmessung in den meisten Fällen mit Hilfe von berührenden Verfahren, wie einem analog-digital-Konverter, durchgeführt wird. Für die Messung des Stromflusses stehen berührungslose Methoden, wie zum Beispiel Hall-Sensoren oder Rogowski-Spulen, zur Verfügung. Für berührungslose Spannungsmessungen können makroskopische Feldmühlen verwendet werden.

Aufgabe der vorliegenden Erfindung ist es eine Messvorrichtung, eine Anordnung sowie ein Verfahren zu schaffen, mittels welchen berührungslos eine elektrische Größe an einem Leiter bestimmt werden kann.

Diese Aufgabe wird durch eine Messvorrichtung, eine Anordnung sowie ein Verfahren gemäß den unabhängigen Patenansprüchen gelöst. Vorteilhafte Ausgestaltungsformen sind in den Unteransprüchen angegeben.

Ein Aspekt der Erfindung betrifft eine Messvorrichtung zum Bestimmen einer elektrischen Größe in einem Leiter, mit zumindest einer Spannungsmesseinrichtung und einer Strommesseinrichtung, wobei die Messvorrichtung zum berührungslosen Bestimmen der elektrischen Größe an dem elektrischen Leiter ausgebildet ist.

Es ist dabei vorgesehen, dass die Messvorrichtung zusätzlich eine Abstandmesseinrichtung zum Bestimmen des Abstands der Messvorrichtung zu dem Leiter aufweist.

Insbesondere kann somit auch die Spannung berührungslos gemessen werden. Somit kann insgesamt die elektrische Größe berührungslos bestimmt werden.

Insbesondere wird somit eine Messvorrichtung präsentiert, welche die beiden Probleme der Netztrennung und der Sicherheitsanforderungen durch ein berührungsloses Verfahren löst.

Insbesondere ist somit eine Kombination von zwei berührungslosen Messverfahren basierend auf Mikrosensoren vorgeschlagen. Zur Messung der Spannung wird beispielsweise auf ein sogenanntes MEMS-Voltmeter (MEMS - mikroelektromechanisches System) zurückgegriffen. Hierbei kann beispielsweise ein elektrisches Feld gemessen werden, da der Leiter insbesondere bei Stromdurchfluss ein elektrisches Feld erzeugt. Dieses kann gemessen werden und kombiniert mit der Strommessung kann dann eine elektrische Größe, beispielsweise eine elektrische Leistung innerhalb des Leiters entsprechend bestimmt werden.

Insbesondere durch die zeit- und ortsgleiche Bestimmung von Strom- und Spannungsverlauf kann durch eine einfache Multiplikation der beiden Werte beispielsweise der aktuelle Leistungsfluss im Leiter berechnet werden oder auch durch eine zeitliche Indikation der Energiefluss durch den Leiter bestimmt werden. Wichtig für dieses Prinzip ist die genaue Kenntnis des Abstands der Messvorrichtung zum spannungs-/stromführenden Bauteil, da beide Messgrößen E, mit anderen Worten das elektrische Feld und B, mit anderen Worten das magnetische Feld, davon abhängen.

Die Neuheit der Erfindung besteht somit darin, dass der Abstand zur Leitung, beziehungsweise zum Leiter, insbesondere zu einer Hochspannungsleitung, nicht mit Hilfe eines mechanischen Abstandshalters eingestellt wird, sondern stattdessen mithilfe der weiteren Messeinrichtung, insbesondere der Abstandsmesseinrichtung, präzise bestimmt wird. Dies eröffnet die Möglichkeit berührungslos und auf größere Entfernung Energieflüsse zu messen.

Insbesondere ermöglicht somit die Erfindung eine berührungslose Leistungs-/Energiemessung beispielsweise in einem Hochspannungssystem. Es können damit sehr hohe Sicherheitsanforderungen eingehalten werden. Ferner kann in das bestehende System die Messvorrichtung eingebaut werden, ohne dabei Eingriff in das eigentliche System durchführen zu müssen. Insbesondere in weitverteilen Stromsystemen können auf dieser einfachen und kostengünstigen Weise Energieflüsse gut überwacht werden. Ferner kann das Verfahren benutzt werden, um Leistungsverluste örtlich gut aufzulösen. Dies kann benutzt werden, um beispielsweise in Umspannwerken zum Beispiel den Verschleiß von Kontaktsystemen, beispielsweise aufgrund von Alterung, aufzudecken.

Gemäß einer vorteilhaften Ausgestaltungsform ist die Spannungsmesseinrichtung zum Erfassen eines elektrischen Feldes des Leiters ausgebildet. Insbesondere das elektrische Feld, welches von einem Leiter unter Spannung erzeugt wird, ändert sich in Abhängigkeit von dem Abstand zur Quelle, üblicherweise linear oder quadratisch, je nach Anordnung. Objekte in der Umgebung, insbesondere zum Beispiel Hochspannungsmasten oder dergleichen, können aber für weitere Änderungen des Feldes durch Influenz und/oder Polarisation sorgen. Mit anderen Worten können auch die Hochspannungsmasten beziehungsweise Objekte in der Umgebung entsprechend berücksichtig werden, um die elektrische Feldbestimmung durchzuführen. Falls aber keine weitere nicht-konstante Spannungsquelle vorhanden ist, ändert sich das Feld linear zur Spannung. Dadurch kann das elektrische Feld, welches von einem Sensor in einer beliebigen und festen Position gemessen wird über folgende lineare Funktion beschrieben werden:

$$E_{Sens} = k \cdot U$$

Mit $E_{sens}$ als gemessenes elektrischen Feld, k einem vorgegebene Faktor und U der Spannung.

Dabei wird angenommen, dass die Spannungsmesseinrichtung 22 die Komponente des elektrischen Feldes E, welche orthogonal zur Oberfläche des Sensors steht, misst.

Für kleiner Änderungen des Abstands zwischen Leiter und Sensor kann angenommen werden, dass sich k über eine Funktion des Abstands r beschreiben lässt (k=f(r)). Je nach Anordnungen und Bedingungen, kann k rechnerisch, simulativ oder durch Kalibrierung ermittelt werden.

Bei Vorhandensein von mehreren veränderlichen Spannungen, kann das gemessene Feld, dank des Superpositionsprinzips, wie folgt beschrieben werden:

$$E_{Sens} = k_1 \cdot U_1 + k_2 \cdot U_2 + \cdots + k_n \cdot U_n$$

Um Störsignale beziehungsweise überlagernde Felder aus anderen Leitern herausrechnen zu können ist es auch möglich mehrere Messeinrichtungen zu platzieren.

Weiterhin vorteilhaft ist, wenn die Messvorrichtung eine elektronische Recheneinrichtung aufweist, wobei die elektronische Recheneinrichtung dazu ausgebildet ist, in Abhängigkeit von dem elektrischen Feld und dem Abstand die elektrische Größe zu bestimmen. Somit kann mittels der elektronischen Recheneinrichtung eine Bestimmung auf Basis des elektrischen Felds und des Abstands durchgeführt werden.

Eine weitere vorteilhafte Ausgestaltungsform sieht vor, dass die elektronische Recheneinrichtung zusätzlich dazu ausgebildet ist, die elektrische Größe zu bestimmen, wobei als elektrische Größe ein elektrischer Leistungsfluss und/oder ein elektrischer Energiefluss bestimmt wird. Insbesondere durch die zeit- und ortsgleiche Bestimmung von Strom- und Spannungsverlauf kann durch eine einfache Multiplikation der beiden Werte der aktuelle Leistungsfluss im Leiter berechnet werden oder auch durch eine zeitliche Integration der Energiefluss durch den Leiter bestimmt werden. Somit kann zuverlässig die elektrische Größe bestimmt werden.

Ferner hat es sich als vorteilhaft erwiesen, wenn die elektronische Recheneinrichtung zusätzlich dazu ausgebildet ist, eine Längenänderung des Leiters zu bestimmen und bei der Bestimmung der elektrischen Größe zu berücksichtigen. Insbesondere kann eine durch eine Längenänderung induzierte Änderung des (Mess-) Abstands bestimmt werden. Insbesondere kann mithilfe der Abstandsmessung auch eine Veränderung der Durchhängung des Kabels, insbesondere beispielsweise bei der Temperaturerhöhung, und dadurch des Abstands zum Kabel-Sensor kompensiert werden. Dadurch kann hochpräzise eine Bestimmung der elektrischen Größe realisiert werden.

Es hat sich weiterhin als vorteilhaft erwiesen, wenn die Abstandsmesseinrichtung als ein Lidarsensor und/oder ein Radarsensor und/oder ein Ultraschallsensor ausgebildet ist. Somit kann auf unterschiedliche Arten und Weisen eine Abstandsmessung durchgeführt werden. Insbesondere sind die entsprechenden Sensoren hochpräzise, wodurch eine präzise Abstandsmessung durchgeführt werden kann. Dies ermöglicht wiederrum eine präzise Bestimmung der elektrischen Größe.

Ferner hat es sich als vorteilhaft erwiesen, wenn die Messvorrichtung zum Bestimmen der elektrischen Größe an einer Hochspannungsleitung als Leiter ausgebildet ist. Beispielsweise können die Messvorrichtungen dann benachbart zur Hochspannungsleitung angeordnet sein. Insbesondere bei Hochspannungsleitungen, bei welchen es schwierig ist, eine elektrische Größe zu messen, kann somit hochflexibel die Messvorrichtung eingesetzt werden.

In der weiteren vorteilhaften Ausgestaltungsform ist vorgesehen, dass die Spannungsmesseinrichtung als eine elektrische Feldmühle ausgebildet ist. Bei der elektrischen Feldmühle handelt es sich insbesondere um die sogenannte MEMS-Messeinrichtung. Insbesondere erzeugt nämlich ein unter Spannung stehendes Messobjekt ein elektrisches Feld. Dieses elektrische Feld wird mithilfe des "MEMS-Voltmeters" berührungslos gemessen. Kombiniert wird nun die Spannungsmessung mit einer berührungslosen Strommessung auf Basis eines Hallsensors oder einer Rogowski-Spule, so kann man mithilfe einer einfachen Rechenoperation die momentane Leistung im Leiter beziehungsweise den zeitlich integrierten Energiefluss im Leiter bestimmen. Die Strommessung nutzt dabei als physikalische Messgröße das durch bewegte Ladungen erzeugte Magnetfeld.

Ferner hat es sich als vorteilhaft erwiesen, wenn die Messvorrichtung dazu ausgebildet ist, unabhängig von der Spannungsmesseinrichtung und der Strommesseinrichtung den Abstand zu bestimmen. Insbesondere ist es somit nicht notwendig, dass die Abstandsbestimmung kontinuierlich durchgeführt werden muss, sondern kann vor oder während der Messung zum Beispiel in bestimmten Intervallen durchgeführt werden. Insbesondere, da eine Abstandsänderung zeitlich nicht so variabel ist, wie beispielsweis die Spannungsmessung, kann somit in geringeren Zeitabständen der Abstand gemessen werden. Dies reduziert den Aufwand.

Es hat sich weiter als vorteilhaft erwiesen, wenn die Messvorrichtung dazu ausgebildet ist zumindest zwei elektrische Größen für zumindest zwei Leiter zu bestimmen. Insbesondere bei Vorhandensein von mehreren veränderlichen Spannungen, kann das gemessene elektrische Feld, dank des Superpositionsprinzips wie folgt beschrieben werden:

$$E_{Sens} = k_1 \cdot U_1 + k_2 \cdot U_2 + \cdots + k_n \cdot U_n$$

Um Störsignale beziehungsweise überlagernde Felder aus anderen Leitern herausrechnen zu können, ist es möglich mehrere Messeinrichtungen zu platzieren. Die Anordnung der Messeinrichtung kann sich an der räumlichen Anordnung der unterschiedlichen Leiter orientieren. Die Mehrheit an Messeinrichtungen kann gleichzeitig dazu verwendet werden, um die Leistungen der anderen Phasen beziehungsweise Leiter zu messen. Um die Spannungen von n Leitern zu messen werden n-Sensoren benötigt. Dann ergeben sich die gemessenen Felder:

$$E_{Sens,1} = k_{1,1} \cdot U_1 + k_{1,2} \cdot U_{1,3} + \cdots + k_{1,n} \cdot U_n$$
$$E_{Sens,2} = k_{2,1} \cdot U_1 + k_{2,2} \cdot U_2 + \cdots + k_{1,n} \cdot U_n$$
$$\vdots$$
$$E_{Sens,n} = k_{n,1} \cdot U_1 + k_{n,2} \cdot U_2 + \cdots + k_{n,n} \cdot U_n$$

Dies stellt ein lineares Gleichungssystem mit n-Gleichungen und n unbekannten Spannungen dar und kann gelöst werden. Falls es ich bei den Leitern um Phasenleiter eines Dreiphasensystems handelt, ist es möglich, Informationen zu den Phasen zu verwenden, um die Anzahl an Sensoren zu verringern oder eine exaktere Messung zu erreichen. Die dargestellten Zusammenhänge können dabei auch analog für das Magnetfeld zur Bestimmung der Ströme verwendet werden.

Ferner hat es sich als vorteilhaft erwiesen, wenn die Strommesseinrichtung einen Hall-Sensor und/oder eine Rogowski-Spule aufweist. Somit kann auf einfache Art und Weise und dennoch zuverlässig und berührungslos die Strommessung am Leiter durchgeführt werden.

Ein weiterer Aspekt der Erfindung betrifft eine Anordnung mit zumindest einer Messvorrichtung nach dem vorgehenden Aspekt und mit einem Leiter, wobei die Messvorrichtung beabstandet zu dem Leiter abgeordnet ist. Insbesondere berühren sich Leiter und Messvorrichtung nicht. Somit kann beispielsweise bei einer Hochspannungsleitung auch entfernt von der Hochspannungsleitung zuverlässig die elektrische Größe bestimmt werden.

Eine weitere vorteilhafte Ausgestaltungsform sieht vor, dass die Messvorrichtung an einen Strommast zum Halten des Leiters angeordnet ist. Alternativ kann die Messvorrichtung auch in der Nähe des Leiters oder in der Nähe der Halterung angebracht sein. Beispielsweise kann dann auch berührungslos am Strommast und mit beispielsweise relativ betrachtet vorgegebenen Abstand die Messvorrichtung die elektrische Größe entsprechend messen.

Gemäß einer weiteren Ausgestattungsform weist die Anordnung zumindest die Messvorrichtung nach dem vorhergehenden Aspekt auf und den Leiter, wobei die Messvorrichtung an dem Leiter angeordnet ist. Beispielsweise kann die Messvorrichtung dann an einem Kabelträger angeordnet sein beziehungsweise kann auch eine direkte Befestigung an der Leitung selbst möglich sein. Insbesondere ist jedoch eine elektrische Kontaktierung zwischen dem Leiter und der Messvorrichtung nicht vorhanden.

Ein nochmals weiterer Aspekt der Erfindung betrifft ein Verfahren zum Bestimmen einer elektrischen Größe in einem Leiter mittels einer Messvorrichtung nach dem vorhergehenden Aspekt. Es wird ein elektrisches Feld des Leiters mittels der Spannungsmesseinrichtung erfasst. Es wird ein Strom des Leiters mittels der Strommesseinrichtung erfasst.

Es erfolgt ein Erfassen eines Abstands des Leiters zur Messvorrichtung mittels der Abstandsbestimmungseinrichtung. Es wird die elektrische Größe in Abhängig von dem erfassten elektrischen Feld, dem erfassten Strom und dem erfassten Abstand bestimmt.

Vorteilhafte Ausgestaltungsformen der Messvorrichtung sind als vorteilhafte Ausgestaltungsformen der Anordnung sowie des Verfahrens anzusehen. Die Messvorrichtung sowie die Anordnung weisen insbesondere gegenständliche Merkmale auf, um entsprechende Verfahrensschritte durchführen zu können.

Ferner betrifft die Erfindung daher auch ein Computerprogrammprodukt mit Programmcodemitteln, welche eine elektronische Recheneinrichtung veranlassen, wenn die Programmcodemittel von der elektronischen Rechnungsmaschine abgearbeitet werden, einfach Verfahren nach dem vorhergehenden Aspekt durchzuführen.

Weiterhin betrifft die Erfindung auch ein computerlesbares Speichermedium mit zumindest dem Computerprogrammprodukt nach dem vorhergehenden Aspekt. Das Verfahren wird dabei insbesondere mittels der Messvorrichtung im Wesentlichen durchgeführt.

Unter einer Recheneinheit/elektronische Recheneinrichtung kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

FIG 1 eine schematische Seitenansicht einer Ausführungsform einer Anordnung

FIG 2 eine weitere schematische Seitenansicht einer weiteren Ausführungsform einer Anordnung;

FIG 3 eine nochmals weitere schematische Seitenansicht einer nochmals weiteren Ausführungsform einer Anordnung;

FIG 4 ein schematisches Blockschreibbild gemäß einer Ausführungsform einer Messvorrichtung.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

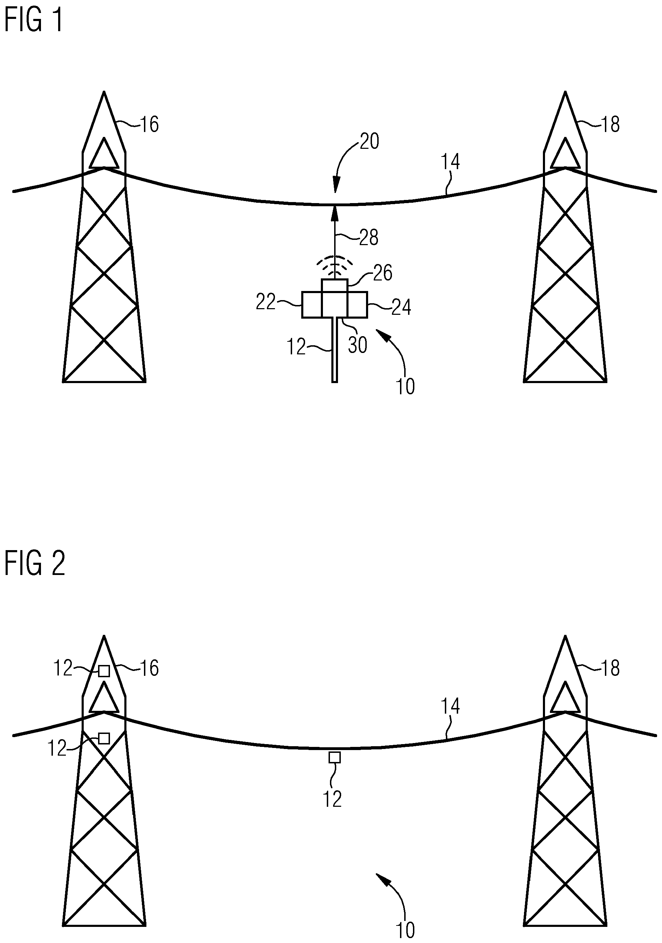

FIG 1 zeigt eine schematische Seitenansicht einer Ausführungsform einer Anordnung 10. Die Anordnung weist zumindest eine Messvorrichtung 12 sowie einen Leiter 14, insbesondere einen elektrischen Leiter 14 auf. Im vorliegenden Ausführungsbeispiel ist der elektrische Leiter 14 insbesondere als Hochspannungsleiter beziehungsweise Hochspannungsleitung ausgebildet. Der Leiter 14 ist vorliegend an einem ersten Strommast 16 sowie an einem zweiten Strommast 18 angeordnet.

In dem vorliegenden Ausführungsbeispiel ist gezeigt, dass die Anordnung 10 insbesondere die Messvorrichtung 12 beabstandet zum Leiter (14) eingeordnet ist.

Gemäß einer Ausgestaltungsform ist die Messvorrichtung 12 zum Bestimmen einer elektrischen Größe 20 in dem Leiter 14 ausgebildet. Die Messvorrichtung 12 weist hierzu zumindest eine Spannungsmesseinrichtung 22 sowie eine Strommesseinrichtung 24 auf. Die Messvorrichtung 12 ist dabei insbesondere zum berührungslosen Bestimmen der elektrischen Größe 20 in dem elektrischen Leiter 14 ausgebildet.

Es ist dabei vorgesehen, dass die Messvorrichtung 12 zusätzlich eine Abstandsmesseinrichtung 26 zum Bestimmen eines Abstandes 28 der Messvorrichtung 12 zu dem Leiter 14 aufweist.

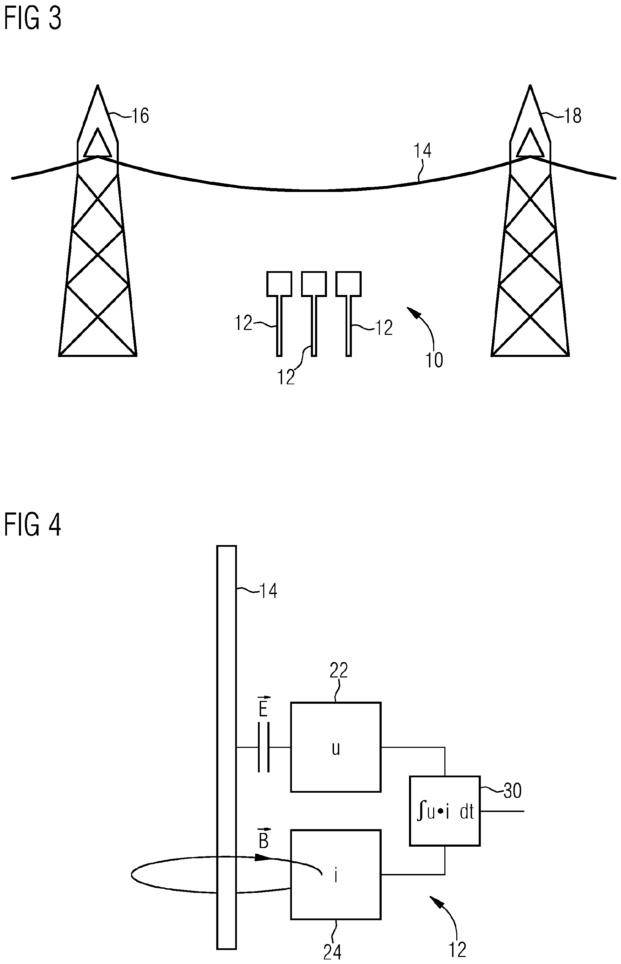

Dabei ist insbesondere vorgehsehen, dass die Spannungsmesseinrichtung 22 zum Erfassen eines elektrischen Feldes E (FIG 4) des Leiters 14 ausgebildet ist. Ferner ist insbesondere vorgehsehen, dass die Messvorrichtung 12 eine elektronische Rechnungseinrichtung 30 aufweist, wobei die elektronische Rechnung 30 dazu ausgebildet ist in Abhängigkeit von dem elektrischen Feld E und dem Abstand 28 die elektrische Größe 20 zu bestimmen. Dabei kann die elektronische Recheneinrichtung 30 zusätzlich dazu ausgebildet sein die elektrische Grö-ße 20 zu bestimmen, wobei als elektrische Größe 20 ein elektrischer Leistungsfluss und/oder elektrischer Energiefluss bestimmt wird. Des Weiteren kann die elektronische Rechnung 30 dazu ausgebildet sein eine Längenänderung des Leiters 14 zu bestimmen und bei der Bestimmung der elektrischen Größe 20 zu berücksichtigen. Insbesondere kann eine durch eine Längenänderung induzierte Änderung des (Mess-) Abstands bestimmt werden.

Die FIG 1 zeigt weiterhin, dass die Abstandsmesseinrichtung 26 als ein Lidarsensor und/oder als ein Radarsensor und/oder als ein Ultraschallsensor ausgebildet sein kann.

Dabei kann ferner vorgesehen sein, dass die Messvorrichtung 12 dazu ausgebildet ist, unabhängig von der Spannungsmesseinrichtung 22 und der Strommesseinrichtung 24 den Abstand 28 zu bestimmen.

Insgesamt zeigt somit die FIG 1, dass durch die zeit- und ortsgleiche Bestimmung von Strom- und Spannungsverlauf durch eine einfache Multiplikation der beiden Werte der aktuelle Leistungsfluss im Leiter 14 berechnet werden kann oder auch eine zeitliche Integration der Energiefluss durch den Leiter 14 berechnet werden kann. Wichtig für dieses Messprinzip ist die genaue Kenntnis des Abstandes 28 der Messvorrichtung 12 zum spannungs- und stromführenden Bauteil, da beide Messgrö-ßen B, also da magnetische Feld (FIG 4) sowie E, also das elektrische Feld, davon abhängen.

Die Neuheit besteht nun insbesondere darin, dass der Abstand 28 zur beispielsweise Hochspannungsleitung nicht mithilfe eines mechanischen Abstandshalters eingestellt wird, sondern stattdessen mit Hilfe der weiteren Abstandmesseinrichtung 26 präzise bestimmt wird. Diese eröffnet die Möglichkeit berührungslos und auf größerer Entfernung Energieflüsse zu messen.

FIG 2 zeigt eine weitere schematische Ansicht einer Ausführungsform der Anordnung 10 mit unterschiedlichen angeordneten Messvorrichtungen 12. Insbesondere zeigt die FIG 2, dass beispielsweise eine Messvorrichtung 12 direkt an dem Leiter 14 eingeordnet werden kann, wobei insbesondere kein elektrischer Kontakt zwischen dem Leiter 14 und der Messvorrichtung 12 ausgebildet ist. Ferner zeigt die FIG 2, dass beispielsweise auch an den Strommast 18 eine Messvorrichtung 12 ausgebildet sein kann. Insbesondere ist es auch möglich, die Messvorrichtungen 12, wie in der FIG 2 gezeigt, an beispielsweise den Kabelträgern oder den Strommasten 16, 18 zu installieren. Auch die direkte Befestigung an dem Leiter 14 ist, wie bereits erwähnt, möglich.

Das elektrische Feld E, welches von dem Leiter 14 unter Spannung erzeugt wird, ändert sich in Abhängigkeit vom Abstand 28 zur Quelle, üblicherweise linear oder quadratisch, je nach Anordnung. Objekte in der Umgebung, beispielsweise der Strommast 16, 18, können für weitere Änderungen des elektrischen Feldes E durch Influenz und/oder Polarisation sorgen. Falls aber keine nicht-konstante Spannungsquelle vorhanden ist, ändert sich das elektrische Feld E linear zur Spannung. Dadurch kann das elektrische Feld E, welches von einem Sensor, insbesondere der Spannungsmesseinrichtung 22, in einer beliebigen und festen Position gemessen werden über folgende lineare Funktion beschrieben:

$$E_{Sens} = k \cdot U$$

Dabei wird angenommen, dass die Spannungsmesseinrichtung 22 die Komponente des elektrischen Feldes E, welche orthogonal zur Oberfläche des Sensors steht, misst.

Für kleiner Änderungen des Abstandes 28 zwischen dem Leiter 14 und der Spannungsmesseinrichtung 22 kann angenommen werden, dass sich k über eine Funktion des Abstands 28 r beschreiben lässt (k=f(r)). Je nach Anordnung und Bedingungen kann k rechnerisch oder durch Kalibrierung ermittelt werden. Bei Vorhandensein von mehreren veränderlichen Spannungen, kann das gemessene elektrische Feld E, dank des Superpositionsprinzips, wie folgt beschrieben werden:

$$E_{Sens} = k_1 \cdot U_1 + k_2 \cdot U_2 + \cdots + k_n \cdot U_n$$

Die Spannungen müssen dabei auf dasselbe Bezugspotential bezogen sein. Die FIG 3 zeigt eine weitere schematische Seitenansicht gemäß einer Ausführungsform der Anordnung 10. Im folgenden Ausführungsbeispiel sind insbesondere drei Messvorrichtungen 12 gezeigt. Dies kann beispielsweise dann vorteilhaft sein, sollten drei Leiter 14 vorgesehen sein. Insbesondere um Störsignale beziehungsweise überlagerte elektrische Felder E aus anderen Leitern 14 herausrechnen zu können ist es auch möglich mehrere Messvorrichtungen 12 zu platzieren. Die Anordnung der Messvorrichtungen 12 kann sich an der räumlichen Anordnung der Leiter 14 orientieren. Die Mehrheit der Messrichtungen 12 kann gleichzeitig dazu verwendet werden, um die Leistungen der anderen Phasen zu messen. Um die Spannungen von n-Leitern zu messen, werden n-Sensoren benötigt. Dann ergeben sich die gemessenen Felder:

$$E_{Sens,1} = k_{1,1} \cdot U_1 + k_{1,2} \cdot U_{1,3} + \cdots + k_{1,n} \cdot U_n$$
$$E_{Sens,2} = k_{2,1} \cdot U_1 + k_{2,2} \cdot U_2 + \cdots + k_{1,n} \cdot U_n$$

$$\vdots$$

$$E_{Sens,n} = k_{n,1} \cdot U_1 + k_{n,2} \cdot U_2 + \cdots + k_{n,n} \cdot U_n$$

Diese bilden ein Gleichungssystem mit n-Gleichungen und n-unbekannten Spannungen und dieses kann entsprechend gelöst werden. Falls es sich bei den Leitern 14 um Phasenleiter eines Drei-Phasen-Systems handelt, ist es möglich, Informationen zu den Phasen zu verwenden, um die Anzahl an Messvorrichtungen 12 zu verringern oder eine exaktere Messung zu erreichen.

Ferner kann analog das Verfahren auch für das Magnetfeld B zur Bestimmung der Ströme verwendet werden.

Zur Bestimmung des Abstands 28 sind mehrere Verfahren möglich. Dies kann zum Beispiel mithilfe von Radarsensoren oder mithilfe von optischen Anstandsmessungen geschehen. Die Abstandsbestimmung muss prinzipiell nicht kontinuierlich durchgeführt werden, sondern kann auch vor oder während der Messung zum Beispiel in bestimmten Intervallen durchgeführt werden.

Mithilfe der Abstandsmessung kann auch eine Veränderung der Durchhängung des Leiters 14, beispielsweise aufgrund einer Temperaturerhöhung, und somit des Abstands Kabel-Sensor kompensiert werden.

FIG 4 zeigt ein schematisches Blockschaltbild gemäß einer Ausführungsform einer Messvorrichtung 12. Vorliegend wird insbesondere gezeigt, dass die Messvorrichtung 12 die Kombination von zwei berührungslosen Messverfahren basierend auf Mikrosensoren nutzt. Zur Messung mit der Spannung wird insbesondere auf das sogenannte Prinzip des MEMS-Voltmeters, welches auch als Feldmühle bezeichnet wird, zurückgegriffen. Ein unter Spannung stehendes Messobjekt, insbesondere Leiter 14, erzeugt dabei das elektrische Feld E. Dieses elektrische Feld E wird mithilfe des MEMS berührungslos gemessen. Kombiniert nun wird die Spannungsmessung mit einem berührungslosen Strommessung auf Basis eines Hall-Sensors oder einer Rogowski-Spule, wobei insbesondere hierbei ein magnetisches Feld B gemessen wird. Mithilfe von einfachen Rechenoperationen, beispielsweise mittels der elektronischen Rechnung 30, kann die momentane Leistung im Leiter 14 beziehungsweise den zeitlich integrierten Energiefluss im Leiter 14 bestimmt werden. Die Strommessung nutzt als physikalische Messgröße das durch bewegte Ladungen erzeugte magnetische Feld B.

Bezugszeichenliste

10   Anordnung
12   Messvorrichtung
14   Leiter
16   erster Strommast
18   zweiter Strommast
20   elektrische Größe
22   Spannungsmesseinrichtung
24   Strommesseinrichtung
26   Abstandsmesseinrichtung
28   Abstand
30   elektronische Recheneinrichtung
B    magnetisches Feld

E    elektrisches Feld

**Patentansprüche**

1.  Messvorrichtung (12) zum Bestimmen einer elektrischen Grö-ße (20) in einem elektrischen Leiter (14), mit zumindest einer Spannungsmesseinrichtung (22) und einer Strommesseinrichtung (24), wobei die Messvorrichtung (12) zum berührungslosen Bestimmen der elektrischen Größe (20) in dem elektrischen Leiter (14) ausgebildet ist,
    **dadurch gekennzeichnet, dass**
    die Messvorrichtung (12) zusätzlich eine Abstandsmesseinrichtung (26) zum Bestimmen eines Abstands (28) der Messvorrichtung (12) zu dem Leiter (14) aufweist.

2.  Messvorrichtung (12) nach Anspruch 1, **dadurch gekennzeichnet, dass**
    die Spannungsmesseinrichtung (22) zum Erfassen eines elektrischen Felds (E) des Leiters (14) ausgebildet ist.

3.  Messvorrichtung (12) nach Anspruch 2, **dadurch gekennzeichnet, dass**
    die Messvorrichtung (12) eine elektronische Recheneinrichtung (30) aufweist, wobei die elektronische Recheneinrichtung (30) dazu ausgebildet ist in Abhängigkeit von dem elektrischen Feld (E) und dem Abstand (28) die elektrische Größe (20) zu bestimmen.

4.  Messvorrichtung (12) nach Anspruch 3, **dadurch gekennzeichnet, dass**
    die elektronische Recheneinrichtung (30) zusätzlich dazu ausgebildet ist die elektrische Größe (20) zu bestimmen, wobei als elektrische Größe (20) ein elektrischer Leistungsfluss und/oder ein elektrischer Energiefluss bestimmt wird.

5.  Messvorrichtung (12) nach einem der Ansprüche 2 bis 4, **dadurch gekennzeichnet, dass**
    die elektronische Recheneinrichtung (30) zusätzlich dazu ausgebildet ist eine Längenänderung des Leiters (14) zu bestimmen und bei der Bestimmung der elektrischen Größe (20) zu berücksichtigen.

6.  Messvorrichtung (12) nach einem der vorhergehenden Ansprüche, **dadurch gekennzeichnet, dass**
    die Abstandsmesseinrichtung (26) als ein Lidarsensor und/oder ein Radarsensor und/oder ein Ultraschallsensor ausgebildet ist.

7.  Messvorrichtung (12) nach einem der vorhergehenden Ansprüche, **dadurch gekennzeichnet, dass**
    die Messvorrichtung (12) zum Bestimmen der elektrischen Größe (20) an einer Hochspannungsleitung als Leiter (14) ausgebildet ist.

8.  Messvorrichtung (12) nach einem der vorhergehenden Ansprüche, **dadurch gekennzeichnet, dass**
    die Spannungsmesseinrichtung (22) als eine elektrische Feldmühle ausgebildet ist.

9.  Messvorrichtung (12) nach einem der vorhergehenden Ansprüche, **dadurch gekennzeichnet, dass**
    die Messvorrichtung (12) dazu ausgebildet ist unabhängig von der Spannungsmesseinrichtung (22) und der Strommesseinrichtung (24) den Abstand zu bestimmen.

10. Messvorrichtung (12) nach einem der vorhergehenden Ansprüche, **dadurch gekennzeichnet, dass**
    die Messvorrichtung (12) dazu ausgebildet zumindest zwei elektrische Größen (20) für zumindest zwei Leiter (14) zu bestimmen.

11. Messvorrichtung (12) nach einem der vorhergehenden Ansprüche, **dadurch gekennzeichnet, dass**
    die Strommesseinrichtung (24) einen Hallsensor und/oder eine Rogowskispule aufweist.

12. Anordnung (10) mit zumindest einer Messvorrichtung (12) nach einem der Ansprüche 1 bis 11 und mit einem Leiter (14), wobei die Messvorrichtung (12) beabstandet zu dem Leiter (14) angeordnet ist.

13. Anordnung (10) nach Anspruch 12, **dadurch gekennzeichnet, dass**
    die Messvorrichtung (12) an einem Strommast (16, 18) zum Halten des Leiters (14) angeordnet ist.

14. Anordnung (10) mit zumindest einer Messvorrichtung (12) nach einem der Ansprüche 1 bis 11 und mit einem Leiter (14), wobei die Messvorrichtung (12) an dem Leiter (14) angeordnet ist.

**15.** Verfahren zum Bestimmen einer elektrischen Größe (20) in einem Leiter (14) mittels einer Messvorrichtung (12) nach einem der Ansprüche 1 bis 12, mit den Schritten:

- Erfassen eines elektrischen Felds (E) des Leiters (14) mittels der Spannungsmesseinrichtung (22);
- Erfassen eines Stroms des Leiters (14) mittels der Strommesseinrichtung (24);
- Erfassen eines Abstands (28) des Leiters (14) zur Messvorrichtung (12) mittels der Abstandsmesseinrichtung (26); und
- Bestimmen der elektrischen Größe (20) in Abhängigkeit von dem erfassten elektrischen Feld (E), dem erfassten Strom und dem erfassten Abstand (28).

FIG 1

FIG 2

FIG 3

FIG 4

Europäisches Patentamt

European Patent Office

Office européen des brevets

**EUROPÄISCHER RECHERCHENBERICHT**

Nummer der Anmeldung

EP 24 15 1143

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2023/145515 A1 (PINNEY NATHAN DOUGLAS [US] ET AL) 11. Mai 2023 (2023-05-11) * Absatz [0114] - Absatz [0128]; Abbildungen 1,2,5,8 * * Absätze [0030], [0036], [0037], [0041], [0074] - Absatz [0088] * ----- | 1-15 | INV. G01R15/14 G01R15/16 G01R15/20 G01R19/25 ADD. G01R29/08 |
| X | US 2014/343878 A1 (GUDMUNDSSON THORKELL [US] ET AL) 20. November 2014 (2014-11-20) * Absatz [0009] - Absatz [0015]; Abbildungen 1-8 * * Absatz [0081] - Absatz [0095] * ----- | 1,14,15 | |
| X | JP 2021 015119 A (IMAMURA HIROO) 12. Februar 2021 (2021-02-12) * Absätze [0036], [0118]; Abbildungen 1,4 * ----- | 1,15 | |
| X | US 2011/010118 A1 (GAARDER PAL EVEN [NO]) 13. Januar 2011 (2011-01-13) * Absätze [0002], [0027] - Absatz [0036] * * Absätze [0049], [0062], [0063], [0111]; Abbildungen 1,2 * ----- | 1,15 | RECHERCHIERTE SACHGEBIETE (IPC) G01R |
| X | US 2007/052493 A1 (LAPINSKI STERLING [US] ET AL) 8. März 2007 (2007-03-08) * Absätze [0003], [0010], [0011], [0017], [0046] - Absatz [0050]; Abbildungen 3,4,5,8 * ----- | 1,15 | |
| A | DE 10 2008 052477 A1 (SIEMENS AG [DE]) 10. Juni 2010 (2010-06-10) * Absätze [0001], [0004] * ----- | 8 | |

Der vorliegende Recherchenbericht wurde für alle Patentansprüche erstellt

| Recherchenort | Abschlußdatum der Recherche | Prüfer |
|---|---|---|
| München | 16. Mai 2024 | Hof, Klaus-Dieter |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**   EP 24 15 1143

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-05-2024

| Im Recherchenbericht angeführtes Patentdokument | Datum der Veröffentlichung | Mitglied(er) der Patentfamilie | Datum der Veröffentlichung |
|---|---|---|---|
| US 2023145515 A1 | 11-05-2023 | AU 2019211451 A1 | 06-08-2020 |
| | | CA 3089121 A1 | 01-08-2019 |
| | | CN 111699359 A | 22-09-2020 |
| | | EP 3743683 A1 | 02-12-2020 |
| | | JP 2021512584 A | 13-05-2021 |
| | | US 2019235011 A1 | 01-08-2019 |
| | | US 2021215751 A1 | 15-07-2021 |
| | | US 2023145515 A1 | 11-05-2023 |
| | | WO 2019147965 A1 | 01-08-2019 |
| US 2014343878 A1 | 20-11-2014 | US 2014343878 A1 | 20-11-2014 |
| | | WO 2014186612 A1 | 20-11-2014 |
| JP 2021015119 A | 12-02-2021 | JP 7455009 B2 | 25-03-2024 |
| | | JP 2021015119 A | 12-02-2021 |
| US 2011010118 A1 | 13-01-2011 | CA 2699586 A1 | 26-03-2009 |
| | | CN 101809452 A | 18-08-2010 |
| | | DK 2201390 T3 | 21-07-2014 |
| | | EA 201000500 A1 | 30-06-2011 |
| | | EP 2201390 A2 | 30-06-2010 |
| | | HR P20140824 T1 | 10-10-2014 |
| | | US 2011010118 A1 | 13-01-2011 |
| | | US 2020200809 A1 | 25-06-2020 |
| | | US 2021033651 A1 | 04-02-2021 |
| | | WO 2009037163 A2 | 26-03-2009 |
| US 2007052493 A1 | 08-03-2007 | AU 2005336125 A1 | 15-03-2007 |
| | | DK 1922550 T3 | 24-03-2014 |
| | | EP 1922550 A1 | 21-05-2008 |
| | | ES 2442224 T3 | 10-02-2014 |
| | | JP 4796144 B2 | 19-10-2011 |
| | | JP 2009508459 A | 26-02-2009 |
| | | PL 1922550 T3 | 30-06-2014 |
| | | US 2007052493 A1 | 08-03-2007 |
| | | WO 2007030121 A1 | 15-03-2007 |
| DE 102008052477 A1 | 10-06-2010 | KEINE | |

EPO FORM P0461

Für nähere Einzelheiten zu diesem Anhang : siehe Amtsblatt des Europäischen Patentamts, Nr.12/82